# EUROPÄISCHE PATENTANMELDUNG

(11) **EP 1 143 530 A2**
(43) Veröffentlichungstag der Anmeldung: **10.10.2001**
(21) Anmeldenummer: 01108458.9
(22) Anmeldetag: 04.04.2001
(51) Int. Cl.: H01L 31/0352, H01L 31/068

(54) **Solarzelle**

(30) Priorität: 06.04.2000 DE 10016972
(71) Anmelder: Angewandte Solarenergie - ASE GmbH, 63755 Alzenau (DE)
(72) Erfinder: Strobl, Gerhard, Dr., 70439 Stuttgart (DE); Tentscher, Karlheinz, 74081 Heilbronn (DE); Uebele, Paul, 74199 Untergruppenbach (DE)
(74) Vertreter: Stoffregen, Hans-Herbert, Dr. Dipl.-Phys. Patentanwalt

(57) **Zusammenfassung**

Die Erfindung bezieht sich auf eine Solarzelle (10) umfassend einen einen n⁺p-Übergang enthaltenden Halbleiterkörper (12). Damit eine entsprechende Solarzelle ein gutes EOL-Verhalten zeigt, wird vorgeschlagen, dass die Solarzelle (10) erste und zweite Bereiche (28, 30, 32, 34, 48) unterschiedlicher Dicken (d₁, d₂) aufweist, von denen der erste Bereich (28, 30, 48) tragende Struktur der Solarzelle bildet und der zweite Bereich (32, 34) eine erheblich geringere Dicke als der erste Bereich aufweist.

## Beschreibung

Die Erfindung bezieht sich auf eine Solarzelle umfassend ein Halbleitersubstrat, in dem durch einfallende Strahlungsenergie Ladungsträger erzeugbar sind, die durch ein elektrisches Feld trennbar und sodann über elektrisch leitende Kontakte ableitbar sind, insbesondere umfassend einen einen n⁺p-Übergang enthaltenden Halbleiterkörper vorzugsweise mit rückseitig gegebenenfalls partiell ausgebildetem Rückseitenfeld (BSF), wobei die Solarzelle erste und zweite Bereiche unterschiedlicher Dicken aufweist, von denen der erste Bereich tragende Struktur der Solarzelle bildet und der zweite Bereich eine erheblich geringere Dicke als der erste Bereich aufweist.

Wesentliche Voraussetzung zur Erzielung hoher Wirkungsgrade bei photovoltaischen Solarzellen sind neben einer optimalen Einkopplung des Lichtes durch geeignete Oberflächenstrukturierung und Kontaktanordnung vor allem eine möglichst geringe Kontaktfläche und eine sehr gute Oberflächenpassivierung im aktiven Bereich des Halbleiters. Um die in die Solarzelle einfallende Strahlungsenergie optimal zu nutzen, kann ferner rückseitig eine Reflexionsschicht aufgebracht werden, wobei zur Reduzierung hoher Rekombinationsgeschwindigkeiten ein sogenanntes Back-Surface-Field (BSF) oder ein Rückseitenfeld ausgebildet werden kann. Dabei besteht die Möglichkeit, die gesamte Rückseite als BSF oder nach der DE 38 15 512 C2 die Rückseite nur partiell als BSF auszubilden. Hierzu wird bei einer Solarzelle mit n⁺p-Struktur zwischen dem Halbleitersubstrat und rückseitiger Kontaktschicht eine ganzflächige Isolationsschicht angeordnet, die mit Öffnungen zur Bildung eines ohmschen Kontaktes zwischen dem Halbleitersubstrat und der Kontaktschicht versehen ist, wobei von den Öffnungen ausgehend in das Halbleitersubstrat hinein hochdotierte p⁺-Zonen ausgebildet sind. Durch die partielle p⁺-Dotierung zusammen mit der aus hochreinem Oxid, Siliziumnitrid oder Siliziumoxynitrid bestehenden Isolationsschicht wird eine vergleichbare Wirkung wie eine ganzflächig ausgebildete p⁺-Zone erzielt, so dass die Ladungsträgerrekombination sehr gering ist.

Im Weltraum sind Solarzellen hochenergetischer Elektronen-, Protonen- und sonstiger Strahlung ausgesetzt, die ihre Leistungsfähigkeit herabsetzen. Am Anfang der Mission bringen sie ihre BOL (Begin-of-life)- Leistung und nach einer bestimmten Zeit nur noch ihre EOL (End-of-life)- Leistung.

Um ein gutes EOL(end-of-life)-Verhalten zu erzielen, werden dünne Solarzellen bevorzugt, da diese ungeachtet einer geringen Diffusionslänge, die durch Strahlenschäden verursacht werden, einen guten Wirkungsgrad zeigen. Nachteil entsprechender dünner Solarzellen ist es jedoch, dass diese mechanisch instabil sind und insbesondere schwer oder fast überhaupt nicht zu bearbeiten bzw. verarbeitbar sind.

Eine Solarzelle der eingangs genannten Art ist der US 3,802,924 zu entnehmen. Um das Gewicht einer entsprechenden Solarzellen zu reduzieren, weist diese einen umlaufenden Rand einer Dicke zwischen 200 und 300 µm und einer Breite von 1 bis 2 mm auf. Die Dicke der Solarzelle in dem von dem Rahmen umgebenen Bereich beträgt in etwa 100 µm. Die Zellen selbst weisen Abmessungen von 2 x 2 cm ², 2 x 4 cm², 3 x 4 cm² und 2 x 6 cm² auf und sind demzufolge relativ kleinflächig.

Der vorliegenden Erfindung liegt das Problem zu Grunde, eine Solarzelle der eingangs genannten Art, insbesondere eine solche mit einem n⁺p-Übergang sowie gegebenenfalls partiell ausgebildetem p⁺-Rückseitenfeld derart weiterzubilden, dass die gewünschte Solarzelle in einer Dicke zur Verfügung gestellt wird, die ein gutes EOL-Verhalten zeigt, ohne dass wesentliche Einbußen hinsichtlich der mechanischen Stabilität und der Be- bzw. Verarbeitung in Kauf genommen werden müssen.

Erfindungsgemäß wird das Problem im Wesentlichen dadurch gelöst, dass die Solarzelle von ihrer Rückseite ausgehend den zweiten Bereich bildende Ausnehmungen aufweist, die umfangsseitig von Abschnitten der ersten Bereiche begrenzt sind, dass der erste Bereich eine Dicke d₁ mit d₁ ≥ 80 µm, der zweite Bereich eine Dicke d₂ mit 20 µm ≤ d₂ ≤ 80 µm, aufweist, wobei sich die Dicke d₁ des ersten Bereichs zu der Dicke d₂ des zweiten Bereichs verhält wie d₁/d₂ ≥ 1,2 . Insbesondere beträgt d₁ in etwa 100 µm - 150 µm, vorzugsweise 130 µm, und d₂ in etwa 40 µm - 60 µm, vorzugsweise 50 µm.

Erfindungsgemäß wird eine Solarzelle vorgeschlagen, die bereichsweise, d. h. lokal "gedünnt" ist. Dies bedeutet, dass Bereiche, die im Wesentlichen tragende Funktion nicht aufweisen, mechanisch sehr instabil sind, wohingegen andere Bereiche die für die Handhabbarkeit der Solarzelle erforderliche mechanische Stabilität bieten. Insbesondere verhält sich die Fläche F₁ der ersten Bereiche zu der Fläche F₂ der zweiten Bereich wie 1 : 40 ≤ F₁ : F₂ ≤ 1 : 3, wobei das Flächenverhältnis in einer Ebene bestimmt wird, in der freie Außenflächen der zweiten Bereiche verlaufen. Dabei verlaufen die Bereiche größerer Dicke nicht nur im Randbereich, sondern auch im Mittenbereich und sind insbesondere als sich kreuzende Stege ausgebildet.

Bevorzugterweise gehen von der Rückseite der Solarzelle Ausnehmungen bzw. Vertiefungen aus, zwischen denen die ersten tragenden Bereiche verlaufen. Dabei können die Ausnehmungen, die die lokale Verdünnung der Solarzelle bewirken, graben- und/oder pyramidenstumpf- und/oder kegelstumpf- und/oder kugelabschnittförmig ausgebildet sein.

Die erfindungsgemäße Solarzelle kann somit auf einem Träger über die über die zweiten Bereiche vorstehenden ersten Bereiche angeordnet wie verklebt werden, wobei gegebenenfalls der Zwischenraum zwischen den zweiten Bereichen und den Abstützflächen der ersten Bereiche mit einem Material ausgefüllt sein kann, dessen Dichte geringer als die Dichte der Solarzelle ist. Insbesondere können die Bereiche mit Kleber oder mit Kleber und Microballons ausgefüllt sein. Hierdurch wird die Gesamtstabilität der Solarzelle erhöht, deren gesamtes Gewicht jedoch erheblich geringer als das einer Solarzelle üblicher Struktur ist, bei der die Solazelle über ihre gesamte Fläche mechanisch stabil ist, also eine im Wesentlichen gleichbleibende Dicke aufweist.

Daher zeichnet sich eine Solarzelle der eingangs genannten Art auch dadurch aus, dass die Solarzelle von ihrer Rückseite ausgehend den zweiten Bereich bildenden Ausnehmungen aufweist, die umfangsseitig von Abschnitten der ersten Bereiche begrenzt sind, und dass die Ausnehmungen zumindest bereichsweise mit einem Material ausgefüllt sind, dessen spezifische Dichte geringer als die Dichte der Solarzelle ist.

Die Ausnehmungen der Solarzelle selbst sind vorzugsweise durch Stege begrenzt, die zur Normalen der Solarzelle einen Winkel α mit 0°≤ α ≤ 60°, insbesondere α ≤ 40° beschreiben können.

Des Weiteren ist vorgesehen, dass die Solarzelle in den Bereichen mit zu z. B. weiteren Solarzellen führenden Kontakten verbunden wie verlötet oder verschweißt ist, die in Normalrichtung der Solarzelle verlaufender Projektion der freien Abstützflächen der ersten Bereiche liegen.

Die Fläche, von der die Ausnehmungen nicht ausgehen, also insbesondere die Frontfläche der Solarzelle, kann glatt oder auch z. B. durch pyramidenstrumpfförmige Vertiefungen bzw. Erhebungen strukturiert sein. Ferner besteht die Möglichkeit, die frontseitige Halbleiterschicht, also im Falle einer n⁺p-Struktur den Emitter mit integrierten Dioden auszubilden, d. h. es wird bei einem planaren Emitter (pn-Übertragung) ein n⁺/p⁺ - Übergang ausgebildet, der als Zenerdiode wirkt, wenn die Solarzelle im Rückwärtsbetrieb benutzt wird. Insoweit wird auf hinlänglich bekannte Verschaltungen verwiesen.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgen Beschreibung eines der Zeichnung zu entnehmenden bevorzugten Ausführungsbeispiels.

Es zeigen:
- Fig. 1: einen Ausschnitt einer erfindungsgemäßen Solarzelle im Querschnitt und
- Fig. 2: eine Solarzelle in Unteransicht.

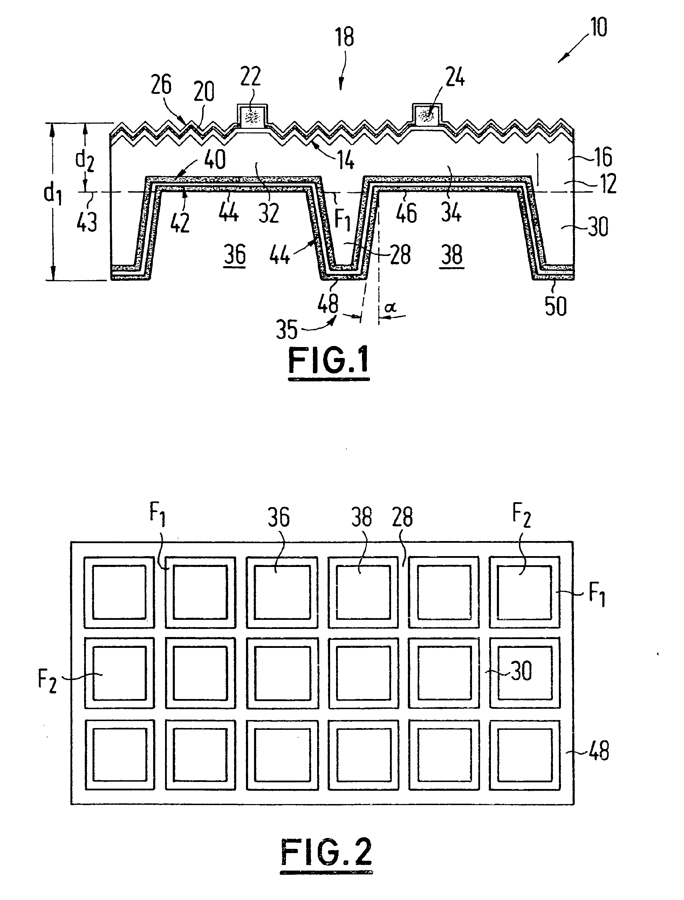

In Fig. 1 ist eine erfindungsgemäße Solarzelle 10 mit einem Halbleitersubstrat oder -körper 12 dargestellt, das bzw. der einen frontseitigen den Emitter bildenden n⁺-Bereich 14 und einen p-dotierten Bereich 16 umfasst, so dass sich von der Vorderseite der Solarzelle 10 ausgehend ein n⁺p-Übergang erstreckt. Auf den n⁺-Bereich ist eine Passivierungsschicht 20 aus z. B. SiO₂, CVD SiO₂, Siliziumnitrid oder eine Doppelschicht SiO₂/Si₃N₄, bevorzugt plasmaunterstützt, aufgebracht. Bekannterweise verlaufen ferner entlang der Oberfläche der von der Passivierschicht 20 befreiten n⁺-Schicht 14 streifenförmige Frontkontakte 22, 24, die z. B. aus Titan-Palladium-Silber bestehen können. Schließlich können die Passivierungsschicht 20 sowie die Kontakte 22, 24 von einer Antireflexionsschicht 26 abgedeckt sein.

Wie die Prinzipdarstellung gemäß Fig. 1 verdeutlicht, kann die Frontseite, also Emitterfläche der Solarzelle 10 strukturiert sein, und zwar durch wellenförmige bzw. pyramidenförmige Strukturen. Insoweit wird jedoch auch auf hinlänglich bekannte Gestaltungen verwiesen.

Um Vorteile einer sehr dünnen Solarzelle zu erzielen, ohne Einbußen in Bezug auf die mechanische Stabilität und damit der Handhabbarkeit in Kauf zu nehmen, wird die erfindungsgemäße Solarzelle 10 bereichsweise sehr dünn ausgebildet, also lokal "gedünnt". Dies bedeutet, dass die Solarzelle aus ersten eine mechanische Stabilität sicherstellenden Bereichen 28, 30 und zweiten sehr dünnen Bereichen 32, 34 besteht. Hierzu werden im Ausführungsbeispiel in der Solarzelle 10 von ihrer Rückseite 35 ausgehend Bereiche 36, 38 ausgeätzt, wobei übliche Maskiertechniken zur Anwendung gelangen. Das Ausätzen der Bereiche 36, 38 kann dabei vor Ausbildung der Frontseite 18 erfolgen.

Nach dem lokalen "Dünnen" der Solarzelle 10, also Ausbilden der durch die Ausnehmungen rückseitig begrenzten Bereiche 32, 34 werden die Rückseitenschichten hergestellt, wobei auf der Rückseite 35 ein Rückseitenfeld (BSF) vorzugsweise vollständig, gegebenenfalls lokal ausgebildet wird, wie dies durch die DE 38 15 512 C2 beschrieben ist, auf deren Offenbarung verwiesen wird. Dies bedeutet, dass rückseitig auf das Substrat 12 beispielsweise durch Bondiffusion, Borimplantation, oder Aluminiumlegierung eine p⁺-Zone 40 ausgebildet wird, auf die wiederum eine z. B. aus Oxid bestehende Passivierungsschicht mit Löchern aus Aluminium bestehende Reflexionsschicht 42 und sodann eine Rückkontaktschicht 44 mit z. B. einer Schichtfolge Aluminium-Titan-Palladium-Silber aufgebracht werden, wobei hinlänglich bekannte Techniken zur Anwendung gelangen.

Die nicht weggeätzten Bereiche, also die als Vorsprünge in Erscheinung tretenden Bereiche 28, 30 bilden die erforderliche mechanische Stabilität der Solarzelle 10, wohingegen durch die sehr dünnen Bereiche 32, 34 das gewünschte gute EOL-Verhalten der Solarzelle 10 sichergestellt wird.

Derartige Ausnehmungen oder Vertiefungen 36, 38 können gewünschte Geometrien, also z. B. eine Graben-, Pyramidenstumpf, Kegelstumpf- oder Kugelabschnittform aufweisen. Dabei können die die Ausnehmungen bzw. Vertiefungen 36, 38 begrenzenden Stege 28, 30 sich zum freien Ende hin verjüngen und zur Normalen der Solarzelle 10 einen Winkel α mit α vorzugsweise ≤ 45° beschreiben.

Die ersten die mechanische Stabilität sicherstellenden Bereiche 28, 30, die sich bis zur Frontseite der Solarzelle 10 erstrecken, können eine Dicke d₁ im Bereich zwischen 80 und 200 µm, vorzugsweise im Bereich von 130 µm und die dünnen Bereiche 22, 34 eine Dicke d₂ im Bereich zwischen 20 µm und 80 µm, vorzugsweise im Bereich von 50 µm aufweisen. Die Dickenverhältnisse betragen insbesondere 2,5 ≥ d₁/d₂ ≥ 1,2 mit d₂ zwischen 20 µm und 80 µm.

Das Flächenverhältnis der ersten Bereiche (F₁) zu den zweiten Bereichen (F₂) in einer Ebene 43, die von den Bodenflächen 44, 46, der Aussparungen 36, 38 aufgespannt wird, sollte sich verhalten wie 1 : 40 ≤ F₁ : F₂ ≤ 1 : 3.

Die Solarzelle 10 wird auf einem Träger mit ihren ersten Bereichen 28, 30, d. h. auf deren freien äußeren Flächen 48, 50 abgestützt und gegebenenfalls verklebt werden. Die freien Bereiche der Ausnehmungen bzw. Vertiefungen 36, 38, also zwischen den scheinbaren Vorsprüngen 28, 30, können ebenfalls mit Klebermaterial und/oder mit Klebermaterial und Microballons (kleine Kügelchen, die von einer dünnen Kunststoffhaut gebildet werden und mit Luft gefüllt sind) ausgefüllt werden. Hierdurch erfährt die Solarzelle 10 eine zusätzliche mechanische Stabilität. Ungeachtet dessen weist die entsprechend ausgebildete erfindungsgemäße Solarzelle 10 einen erheblichen Gewichtsvorteil gegenüber massiven Zellen auf.

Fig. 2 ist eine prinzipiell wiedergegebene Unteransicht einer erfindungsgemäßen Solarzelle 10 zu entnehmen, bei der die Aussparungen bzw. Vertiefungen 36, 38 durch Pyramidenstümpfe gebildetet werden. Die ersten, die mechanische Stabilität gewährleistenden Bereiche werden durch sich kreuzende Stege 28, 30 sowie umlaufenden rückseitigen Rand 48 gebildet.

Typische Flächenabmessungen einer erfindungsgemäßen Solarzelle sind bei Verwendung von runden Siliziumwafern eines Durchmesser von 100 mm z. B. 4 cm x 6 cm nominal.

## Patentansprüche

1. Solarzelle (10) umfassend ein Halbleitersubstrat, in dem durch einfallende Strahlungsenergie Ladungsträger erzeugbar sind, die durch ein elektrisches Feld trennbar und sodann über elektrisch leitende Kontakte (22, 24, 44) ableitbar sind, insbesondere umfassend einen einen n⁺p-Übergang enthaltenden Halbleiterkörper (12) vorzugsweise mit rückseitig gegebenenfalls partiell ausgebildetem Rückseitenfeld (BSF), wobei die Solarzelle erste und zweite Bereiche (28, 30, 32, 34, 48) unterschiedlicher Dicken (d₁, d₂) aufweist, von denen der erste Bereich (28, 30, 48) tragende Struktur der Solarzelle bildet und der zweite Bereich (32, 34) eine erheblich geringere Dicke als der erste Bereich aufweist,
**dadurch gekennzeichnet,**
**dass** die Solarzelle (10) von ihrer Rückseite (35) ausgehend den zweiten Bereich bildende Ausnehmungen (36, 38) aufweist, die umfangsseitig von Abschnitten der ersten Bereiche (28, 30) begrenzt sind, dass der erste Bereich (28, 30, 48) eine Dicke d₁ mit d₁ ≥ 80 µm, der zweite Bereich (32, 34) eine Dicke d₂ mit 20 µm ≤ d₂ ≤ 80 µm, aufweist, wobei sich die Dicke d₁ des ersten Bereichs zu der Dicke d₂ des zweiten Bereichs verhält wie d₁/d₂ ≥ 1,2.

2. Solarzelle nach Anspruch 1,
**dadurch gekennzeichnet,**
**dass** der erste Bereich (28, 30, 48) eine Dicke d₁ mit 100 µm ≤ d₁ ≤ 150 µm, und/- oder der zweite Bereich (32, 34) eine Dicke d₂ mit 40 µm ≤ d₂ ≤ 60 µm, aufweist.

3. Solarzelle nach zumindest einem der vorhergehenden Ansprüche,
**dadurch gekennzeichnet,**
**dass** die Solarzelle (10) von ihrer Rückseite (35) ausgehend mehrere Ausnehmungen (36, 38) aufweist, die umfangsseitig von Abschnitte der ersten Bereiche (28, 30) begrenzt sind.

4. Solarzelle nach zumindest einem der vorhergehenden Ansprüche,
**dadurch gekennzeichnet,**
**dass** die Ausnehmungen (36, 38) graben-, pyramidenstumpf-, kegelstumpf- oder kugelabschnittförmig ausgebildet sind.

5. Solarzelle nach zumindest einem der vorhergehenden Ansprüche,
**dadurch gekennzeichnet,**
**dass** die Solarzelle (10) über die ersten Bereiche (28, 30) bzw. deren freien Bodenflächen (48, 50) auf einem Träger abstützbar bzw. mit diesem verklebbar sind.

6. Solarzelle vorzugsweise nach zumindest einem der vorhergehenden Ansprüche,
**dadurch gekennzeichnet,**
**dass** die Ausnehmungen (36, 38) zumindest bereichsweise mit einem Material ausgefüllt sind, dessen spezifische Dichte geringer als die Dichte der Solarzelle (10) ist.

7. Solarzelle nach zumindest einem der vorhergehenden Ansprüche,
**dadurch gekennzeichnet,**
**dass** die Ausnehmungen (36, 38) mit Klebermaterial und/oder Klebermaterial mit Microballons ausgefüllt sind.

8. Solarzelle nach zumindest einem der vorhergehenden Ansprüche,
**dadurch gekennzeichnet,**
**dass** die Ausnehmungen (36, 38) durch Stege als die Abschnitte (28, 30) des ersten Bereichs begrenzt sind, die zur Normalen der Solarzelle (10) einen Winkel α mit 0° ≤ α ≤ 60°, insbesondere α ≤ 40° beschreiben.

9. Solarzelle nach zumindest einem der vorhergehenden Ansprüche,
**dadurch gekennzeichnet,**
**dass** in durch Bodenflächen (44, 46) der Ausnehmungen (36, 38) aufgespannter Ebene (43) die ersten Bereiche (26, 38) eine flächige Erstreckung F₁ und die zweiten Bereiche (32, 34) eine flächige Erstreckung F₂ mit insbesondere 1 : 40 ≤ F₁ : F₂ ≤ 1 : 3 aufweisen.

10. Solarzelle (10) umfassend ein Halbleitersubstrat, in dem durch einfallende Strahlungsenergie Ladungsträger erzeugbar sind, die durch ein elektrisches Feld trennbar und sodann über elektrisch leitende Kontakte (22, 24, 44) ableitbar sind, insbesondere umfassend einen einen n⁺p-Übergang enthaltenden Halbleiterkörper (12) vorzugsweise mit rückseitig gegebenenfalls partiell ausgebildetem Rückseitenfeld (BSF), wobei die Solarzelle erste und zweite Bereiche (28, 30, 32, 34, 48) unterschiedlicher Dicken (d₁, d₂) aufweist, von denen der erste Bereich (28, 30, 48) tragende Struktur der Solarzelle bildet und der zweite Bereich (32, 34) eine erheblich geringere Dicke als der erste Bereich aufweist,
**dadurch gekennzeichnet,**
**dass** die Solarzelle (10) von ihrer Rückseite (35) ausgehend den zweiten Bereich bildenden Ausnehmungen (36, 38) aufweist, die umfangsseitig von Abschnitten der ersten Bereiche (28, 30) begrenzt sind und dass die Ausnehmungen zumindest bereichsweise mit einem Material ausgefüllt sind, dessen spezifische Dichte geringer als die Dichte der Solarzelle (10) ist.
